(19) Europäisches Patentamt
European Patent Office
Office européen des brevets

(11) **EP 4 640 784 A1**

(12) **EUROPEAN PATENT APPLICATION**
published in accordance with Art. 153(4) EPC

(43) Date of publication:
29.10.2025 Bulletin 2025/44

(21) Application number: 23907168.1

(22) Date of filing: 22.12.2023

(51) International Patent Classification (IPC):
C09J 201/00 (2006.01)    C09J 5/00 (2006.01)
C09J 7/35 (2018.01)      C09J 11/04 (2006.01)
C09J 163/00 (2006.01)    C09K 5/12 (2006.01)

(52) Cooperative Patent Classification (CPC):
C09J 5/00; C09J 7/35; C09J 11/04; C09J 163/00;
C09J 201/00; C09K 5/12

(86) International application number:
PCT/JP2023/046060

(87) International publication number:
WO 2024/135808 (27.06.2024 Gazette 2024/26)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 23.12.2022 JP 2022206364

(71) Applicant: Resonac Corporation
Tokyo 105-7325 (JP)

(72) Inventors:
• TAKAHASHI, Nobuyuki
  Tokyo 105-7325 (JP)
• SAITO, Hayato
  Tokyo 105-7325 (JP)
• TAKAHASHI, Kentaro
  Tokyo 105-7325 (JP)
• GORGOLL, Ricardo Mizoguchi
  Tokyo 105-7325 (JP)

(74) Representative: Strehl & Partner mbB
Maximilianstrasse 54
80538 München (DE)

(54) **JOINING METHOD**

(57) Provided is a method for joining a heating element to a heating element or a heat dissipation part to a heat dissipation part through a solid thermally-conductive material. A heating element A and a heat dissipation part B or a heat dissipation part B2 and a heat dissipation part B3 are joined to each other through a solid thermally-conductive material containing a thermoplastic resin and a heat dissipation filler, the thermoplastic resin having a content of 51% by mass or more of a resin component in the solid thermally-conductive material.

[Fig. 1]

B (B3)

C

A (B2)

EP 4 640 784 A1

**Description**

Technical Field

The present invention relates to a joining method through a solid thermally-conductive material.

Background Art

Thermal interface materials (hereinafter abbreviated as "TIMs") are a thermally-conductive material to be inserted between members for efficient dissipation of unnecessary heat generated in the inside of an electronic device. TIMs are generally used in the form of being inserted between a heating element such as an integrated circuit (IC) and a heat dissipation part such as a heat spreader or a heat sink, or in the form of being inserted between heat dissipation parts.
Hitherto, TIMs in various forms, such as a thermal grease (e.g., PTL 1), a thermal gap filler, a phase-change material (hereinafter abbreviated as "PCM") (e.g., PTL 2), and a heat dissipation sheet (e.g., PTL 3), have been known and are each used according to the application.
A thermal grease has been widely used for heat radiation of ICs such as a central processing unit (CPU) because the thermal grease is a viscous liquid material, which is obtained by adding thermally-conductive particles such as metal powder to a resin such as silicone, and curing (heating treatment) is not necessary. Since the thermal grease is in a liquid state, there are an advantage in which the thermal grease can also conform to irregularities, which are a complicated shape, to come into close contact with the irregularities and increase the efficiency of thermal conduction, and an advantage in which the thermal grease has high flexibility and can be subjected to thickness adjustment and the like at the time of application. Meanwhile, there are techniques for individual products regarding the storage of the thermal grease and coating with the thermal grease, and the thermal grease has disadvantages such as low handleability and low suitability for existing production lines. In addition, a phenomenon called "pump-out" in which when the thermal grease is used so as to fill a space between parts having different thermal expansion characteristics, the liquid grease present between the parts gradually extrudes to the outside and reduces by repetition of operation and termination of an apparatus, or a phenomenon in which a volatile component of the resin is removed due to long-term use, and the grease coagulates, becomes powder, and is deteriorated is likely to occur, and problems about reliability remain in the long-term use.
A thermal gap filler is a liquid thermally-conductive gap filling material, and is used to fill an air pocket or a gap by coating an electronic component. Since the thermal gap filler is also in a liquid state, there are advantages in which the thermal gap filler can conform to irregularities, which are a complicated shape, to come into close contact with the irregularities and provide a high-efficiency thermal interface containing no air gap after curing. Meanwhile, the thermal gap filler also has disadvantages such as low handleability and low suitability for existing production lines, like the thermal grease.
A PCM is a thermally-conductive material that contains as a main component a thermoplastic resin and is designed so as to become a solid in a normal-temperature atmosphere and become a liquid at 60°C to 80°C at the time of IC operation. The PCM is softened at the time of IC operation to satisfactorily come into close contact with a heat dissipation device, and therefore the PCM can conform to irregularities, which are a complicated shape, to come into close contact with the irregularities, and increase the efficiency of thermal conduction. However, the state of the PCM is repeatedly changed between a solid and a liquid due to operation and termination of an apparatus, and therefore there are disadvantages in which a volume change and a state change are liable to occur at the time of solidification and voids (gaps) are generated to increase a probability of reducing heat dissipation efficiency. In addition, there are disadvantages in which refrigerated storage is required prior to use and suitability for existing production lines is low. The PCM is solidified at normal temperature to be bonded to an IC or the like, and therefore there is also a disadvantage in which the PCM is difficult to rework a part.
A heat dissipation sheet is a sheet-shaped resin material that is filled with a filler. The heat dissipation sheet is easy to control a thickness that is important for TIMs, is excellent in control of shape, and has a stable performance, and therefore the heat dissipation sheet is suitable for an application that smooths relatively large irregularities, which is difficult for a liquid material. In addition, the heat dissipation sheet is easy to handle and also to rework (exchange) due to its sheet shape, and therefore the heat dissipation sheet is widely used as a thermally-conductive material. However, the heat dissipation sheet is not as soft as a liquid material, is difficult to conform to irregularities, which are a complicated shape, to come into close contact with the irregularities, and cannot be subjected to thickness adjustment and the like at the time of application. Thus, the heat dissipation sheet has a disadvantage in which suitability for design is low.

Citation List

Patent Literature

PTL 1: JP 2006-188638 A
PTL 2: JP 2010-21165 A
PTL 3: JP 2020-13872 A

Summary of Invention

Technical Problem

The present invention has been made in view of such a technological background, and an object of the present invention is to provide a method for joining a heating element to a heat dissipation part, or heat dissipation parts to each other through a solid thermally-conductive material, the method that is suitable for an application in which a TIM that overcomes the disadvantages of the conventional TIMs, has high suitability for existing production lines and high suitability for design, and is less prone to reduce the performance due to long-term use and repetition use is inserted in an electronic device.

In this disclosure, the term "high suitability for existing production lines" means that there is not special limitation regarding storage, coating, and the like and excellent handleability is achieved, and the term "high suitability for design" means that a material can conform to irregularities, which are a complicated shape, to come into close contact with the irregularities, has high flexibility, and can be subjected to thickness adjustment and the like at the time of application.

Solution to Problem

In order to achieve the object, the present invention provides the following means.

<Joining Method>

[1] A method for joining a heating element A to a heat dissipation part B or a heat dissipation part B2 to a heat dissipation part B3 through a solid thermally-conductive material containing a thermoplastic resin and a heat dissipation filler, the thermoplastic resin having a content of 51% by mass or more of a resin component in the solid thermally-conductive material.

[2] The joining method according to [1], in which the solid thermally-conductive material is joined to the heat dissipation part B, and then brought into surface contact of the heating element A in a state where the solid thermally-conductive material is joined to the heat dissipation part B, and the solid thermally-conductive material is melted and solidified to join the heating element A to the heat dissipation part B, or the solid thermally-conductive material is joined to the heat dissipation part B3, and then brought into surface contact of the heat dissipation part B2 in a state where the solid thermally-conductive material is joined to the heat dissipation part B3, and the solid thermally-conductive material is melted and solidified to join the heat dissipation part B2 to the heat dissipation part B3.

[3] The joining method according to [1], in which the solid thermally-conductive material is joined to the heating element A, and then brought into surface contact of the heat dissipation part B in a state where the solid thermally-conductive material is joined to the heating element A, and the solid thermally-conductive material is melted and solidified to join the heating element A to the heat dissipation part B, or the solid thermally-conductive material is joined to the heat dissipation part B2, and then brought into surface contact of the heat dissipation part B3 in a state where the solid thermally-conductive material is joined to the heat dissipation part B2, and the solid thermally-conductive material is melted and solidified to join the heat dissipation part B2 to the heat dissipation part B3.

[4] The joining method according to [1], in which the solid thermally-conductive material is melted and solidified in a state where the heating element A, the solid thermally-conductive material, and the heat dissipation part B are arranged in this order, to join the heating element A to the heat dissipation part B, or the solid thermally-conductive material is melted and solidified in a state where the heat dissipation part B2, the solid thermally-conductive material, and the heat dissipation part B3 are arranged in this order, to join the heat dissipation part B2 to the heat dissipation part B3.

[5] The joining method according to any one of [1] to [4], in which the thermoplastic resin is an amorphous thermoplastic resin having a heat of fusion of 15 J/g or less.

[6] The joining method according to [5], in which the amorphous thermoplastic resin is at least any one of a thermoplastic epoxy resin and a phenoxy resin.

[7] The joining method according to [6], in which the amorphous thermoplastic resin is an amorphous thermoplastic resin having an epoxy equivalent of 1,600 or more or an amorphous thermoplastic resin having no epoxy group.

[8] The joining method according to any one of [1] to [7], in which a content of the heat dissipation filler in the solid thermally-conductive material is 30% by volume to 95% by volume.

[9] The joining method according to any one of [1] to [8], in which the heat dissipation filler is at least any one selected from the group consisting of silver, aluminum oxide, magnesium oxide, aluminum hydroxide, magnesium hydroxide, aluminum nitride, boron nitride, silicon dioxide, carbon black, carbon nanofiber, carbon nanotube, silicon carbide, and silicon nitride.

[10] The joining method according to any one of [2] to [4], in which the melting is performed under a heating condition of 100°C to 400°C and a pressurization condition of 0.01 MPa to 20 MPa.

[11] The joining method according to any one of [2] to [4], in which the solid thermally-conductive material before melting has any shape selected from the group consisting of a film, a rod, a pellet, and a powder.

Advantageous Effects of Invention

The present invention is suitable for an application in which a TIM is inserted in an electronic device. According to the present invention, the disadvantages of the conventional TIMs can be overcome. That is, according to the method of the present invention, a TIM that has high suitability for existing production lines and high suitability for design, and is less prone to reduce the performance due to long-term use and repetition use can be inserted in an electronic device.

Brief Description of Drawings

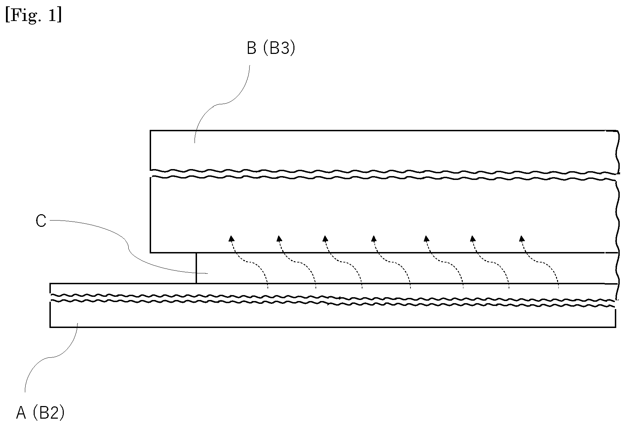

[Fig. 1] Fig. 1 is a view illustrating a thermally-conductive layer in an embodiment of the present invention.

Description of Embodiments

Hereinafter, embodiments of the present invention will be described in detail.

In this disclosure, the term "connection" means that an object and another object are connected to each other so as to be continuous, and the term "joining" is a subordinate concept thereof. In this disclosure, the term "joining" means that an object and another object are connected to each other so as to be in contact with each other, and adhesion and welding are subordinate concepts thereof. The term "adhesion" means that two adherends (to be adhered to each other) are placed in a joined state through an organic material (such as thermosetting resins and thermoplastic resins) such as a tape and an adhesive. The term "welding" means that the surface of a thermoplastic resin or the like is melted by heat and cooled to be coagulated, and entanglement due to molecular diffusion is caused to form a joined state.

[Joining Method]

A specific application of the joining method according to the present invention is not limited, but the joining method is suitable for an application in which a TIM is inserted in an electronic device, and is particularly suitable for an application requiring "high suitability for existing production lines" and "high suitability for design".

<Method for Forming Thermally-conductive Layer in Electronic Device>

An embodiment in which the joining method of the present invention is used in an application that forms a thermally-conductive layer in an electronic device will be described. Specifically, an embodiment in which the joining method of the present invention is used in an application that forms the thermally-conductive layer between a heating element A and a heat dissipation part B or between a heat dissipation part B2 and a heat dissipation part B3 will be described.

The heating element A and the heat dissipation part B or the heat dissipation part B2 and the heat dissipation part B3 are each preferably at least one of ceramic, a carbon material, or metal.

The metal is preferably at least one selected from the group consisting of aluminum, iron, copper, magnesium, and alloys thereof. From the viewpoint of a joining force and strength and from the viewpoint of the strength of an interface joining force to the solid thermally-conductive material, the metal is particularly preferably at least any one of an aluminum alloy and an iron alloy because a robust joined body is obtained.

The ceramic is preferably at least one selected from the group consisting of silicon carbide, aluminum nitride, alumina, silicon nitride, cermet, yttria, forsterite, cordierite, zirconia, and steatite. From the viewpoint of a thermally-conductive property, cost, and ease of molding, the ceramic is more preferably alumina.

At least any one of the group consisting of the heating element A, the heat dissipation part B, the heat dissipation part B2, and the heat dissipation part B3 that are joining objects may be subjected to pretreatment suitable for each member. The pretreatment is preferably pretreatment of cleaning a surface or pretreatment of forming an irregular surface. Specifically, when at least any one of the group consisting of the heating element A, the heat dissipation part B2, the heat dissipation part B, and the heat dissipation part B3 that are joining objects includes aluminum, ceramic, or iron, the pretreatment is preferably at least one selected from the group consisting of degreasing treatment, UV ozone treatment, blasting treatment, grinding treatment, plasma treatment, and etching treatment.

One kind of the pretreatment may be carried out alone, or two or more kinds thereof may be carried out. Known methods can be used as specific methods for these pretreatments.

The thermally-conductive layer can be formed so that the heating element A and the heat dissipation part B, or the heat dissipation part B2 and the heat dissipation part are joined to each other through a solid thermally-conductive material C containing a thermoplastic resin and a heat dissipation filler as shown in Fig. 1.

For example, there are the following a method, b method, and c method.

In an embodiment, the heating element A is a portion in which the temperature becomes higher than the heat dissipation part B, and heat is transferred from the heating element A to the heat dissipation part B. In another embodiment, the heat dissipation part B2 is a portion in which the temperature becomes higher than the heat dissipation part B3, and heat is transferred from the heat dissipation part B2 to the heat dissipation part B.

<a Method>

The a method is a method in which the solid thermally-conductive material C is joined to the heat dissipation part B, and then brought into surface contact of the heating element A in a state where the solid thermally-conductive material C is joined to the heat dissipation part B, and the solid thermally-conductive material C is melted and solidified to join the heating element A to the heat dissipation part B through the solid thermally-conductive material C, or a method in which the solid thermally-conductive material C is joined to the heat dissipation part B3, and then brought into surface contact of the heat dissipation part B2 in a state where the solid thermally-conductive material C is joined to the heat dissipation part B3, and the solid thermally-conductive material C is melted and solidified to join the heat dissipation part B2 to the heat dissipation part B3 through the solid thermally-conductive material C.

In the a method, the solid thermally-conductive material C is first joined to the heat dissipation part B or the heat dissipation part B3 in advance, which is an a1 process.

When the solid thermally-conductive material C is joined to the heat dissipation part B or the heat dissipation part B3 in advance, the heating element can be joined to the heat dissipation part with precision. At this time, the solid thermally-conductive material may have tackiness.

Next, the solid thermally-conductive material C is brought into surface contact with the heating element A or the heat dissipation part B2 in a state where the solid thermally-conductive material C is joined to the heat dissipation part B or the heat dissipation part B3, and the solid thermally-conductive material C is melted and solidified, which is an a2 process.

When the surface of the heating element A or the heat dissipation part B2 has irregularities, the melted solid thermally-conductive material C can be pressed onto the irregularities to conform to the irregularities. The irregularities may be pressed onto the melted solid thermally-conductive material C to allow the solid thermally-conductive material C to conform to the irregularities.

The solid thermally-conductive material C can be solidified in a state where the solid thermally-conductive material C conforms to the irregularities, to join the heating element A to the heat dissipation part B or the heat dissipation part B2 to the heat dissipation part B3.

From the viewpoint of achieving a high joining force, it is preferable that the solid thermally-conductive material be melted by heating at a temperature equal to or more than the melting point of the solid thermally-conductive material.

In the a method, a method for melting and solidifying the solid thermally-conductive material is as described in <<Melting and Solidification>> below.

<b Method>

The b method is a method in which the solid thermally-conductive material C is joined to the heating element A, and brought into surface contact of the heat dissipation part B in a state where the solid thermally-conductive material C is joined to the heating element A, and the solid thermally-conductive material C is melted and solidified to join the heating element A to the heat dissipation part B through the solid thermally-conductive material C. The b method may be a method in which the solid thermally-conductive material C is joined to the heat dissipation part B2, and brought into surface contact of the heat dissipation part B3 in a state where the solid thermally-conductive material C is joined to the heat dissipation part B2, and the solid thermally-conductive material C is melted and solidified to join the heat dissipation part B2 to the heat dissipation part B3 through the solid thermally-conductive material C.

The b method is a method in which the solid thermally-conductive material C is first joined to the heating element A or the heat dissipation part B2 in advance, which is a b1 process.

When the solid thermally-conductive material C is joined to the heating element A or the heat dissipation part B2 in advance, the heating element A and the heat dissipation part B, or the heat dissipation part B2 and the heat dissipation part B3 can be joined to each other with precision. At this time, the solid thermally-conductive material may have tackiness.

Next, the solid thermally-conductive material C is brought into surface contact with the heat dissipation part B or the heat dissipation part B3 in a state where the solid thermally-conductive material C is joined to the heating element A or the heat dissipation part B2, and the solid thermally-conductive material C is melted and solidified, which is an b2 process.

When the surface of the heat dissipation part B or the heat dissipation part B3 has irregularities, the melted solid thermally-conductive material can be pressed onto the heat dissipation part to conform to the irregularities. The irregularities may be pressed onto the melted solid thermally-conductive material to allow the solid thermally-conductive material to conform to the irregularities.

The solid thermally-conductive material can be solidified in a state where the solid thermally-conductive material C conforms to the irregularities, to join the heating element A to the heat dissipation part B or the heat dissipation part B2 to the heat dissipation part B3.

From the viewpoint of achieving a high joining force, it is preferable that the solid thermally-conductive material be melted by heating at a temperature equal to or more than the melting point of the solid thermally-conductive material.

In the b method, a method for melting and solidifying the solid thermally-conductive material is as described in <<Melting and Solidification>> below.

<c Method>

The c method is a method in which the solid thermally-conductive material C is melted and solidified in a state where the heating element A, the solid thermally-conductive material C, and the heat dissipation part B are arranged in this order, to join the heating element A to the heat dissipation part B, or a method in which the solid thermally-conductive material C is melted and solidified in a state in which the heat dissipation part B2, the solid thermally-conductive material C, and the heat dissipation part B3 are arranged in this order, to join the heat dissipation part B2 to the heat dissipation part B3.

In the c method, the heating element A, the solid thermally-conductive material C, and the heat dissipation part B are first arranged and laminated in this order, or the heat dissipation part B2, the solid thermally-conductive material C, and the heat dissipation part B3 are arranged in this order, to form a laminate, which is a c1 process. In the laminate, all the heating element A and the solid thermally-conductive material C, the solid thermally-conductive material C and the heat dissipation part B, the heat dissipation part B2 and the solid thermally-conductive material C, and the solid thermally-conductive material C and the heat dissipation part B3 are not joined to each other, and individual and independent members are superimposed on each other. At this time, the solid thermally-conductive material may have tackiness.

Next, the solid thermally-conductive material C in the laminate is melted and solidified, which is a c2 process.

When the surface of the heating element A or the heat dissipation part B2 has irregularities or the surface of the heat dissipation part B or the heat dissipation part B3 has irregularities, a force can be applied and pressed in a solid thermally-conductive material C direction from the heating element A side or the heat dissipation part B2 side, from the heat dissipation part B side or the heat dissipation part B3 side, or from both the heating element A side or the heat dissipation part B2 side and the heat dissipation part B side or the heat dissipation part B3 side in a state where the solid thermally-conductive material C is melted, and thus the solid thermally-conductive material C can conform to the irregularities.

The solid thermally-conductive material C can be solidified in a state where the solid thermally-conductive material C conforms to the irregularities, to join the heating element A to the heat dissipation part B or the heat dissipation part B2 to the heat dissipation part B3.

When the solid thermally-conductive material in the laminate is melted, from the viewpoint of achieving a high joining force, it is preferable that the solid thermally-conductive material be melted by heating at a temperature equal to or more than the melting point of the solid thermally-conductive material.

In the c method, a method for melting and solidifying the solid thermally-conductive material is as described in <<Melting and Solidification>> below.

<Combination>

A method for incorporating the solid thermally-conductive material may include a combination of at least two processes selected from the a1 process in the a method, the b1 process in the b method, and the c1 process in the c method described above.

One example of the combination includes a combination of the a1 process and the b1 process.

For example, a joined body a in which the solid thermally-conductive material C is joined to the heat dissipation part B by the a1 process is brought into surface contact with a joined body b in which the solid thermally-conductive material C is joined to the heating element A by the b1 process so that the solid thermally-conductive material C of the joined body a faces the solid thermally-conductive material C of the joined body b, and the solid thermally-conductive material C of the joined body a and the solid thermally-conductive material C of the joined body b are melted and solidified. At this time, in a state where the solid thermally-conductive material C is melted, a force can be applied and pressed in the solid thermally-conductive material C direction from the joined body a side, from the joined body b side, or from both the joined body a side and the joined body b side, to form a joined body. That is, in a method for producing a joined body including a combination of the a1 process and the b1 process, the heating element can be joined to the heat dissipation part through use of two solid thermally-conductive materials.

Another example of the combination includes a combination of the a1 process and the c1 process.

For example, in the c1 process, a joined body a in which the solid thermally-conductive material C is joined to the heat dissipation part B by the a1 process is arranged instead of the heat dissipation part B. At this time, the solid thermally-conductive material C joined to the joined body a faces an independent and separate solid thermally-conductive material C. That is, a laminate in which the heating element A, the solid thermally-conductive material C, and the joined body a are arranged and laminated in this order is obtained. Next, both the solid thermally-conductive materials C's in the laminate are melted and solidified. When the solid thermally-conductive material C joined to the joined body a and the independent and separate solid thermally-conductive material C are used so as to be superimposed on each other, the thickness of the joined body can be increased, and a joining force can be enhanced. At this time, in a state where the solid thermally-conductive material C is melted, a force can be applied and pressed in the solid thermally-conductive material C direction from the joined body a side, from the heating element A side, or from both the joined body a side and the heating element A side, to form a joined body. That is, in a method for producing a joined body including a combination of the a1 process and the c1 process, the heating element A can be joined to the heat dissipation part B through use of two solid thermally-conductive materials C's.

Still another example of the combination includes a combination of the b1 process and the c1 process.

For example, in the c1 process, a joined body b in which the solid thermally-conductive material C is joined to the heating element by the b1 process is arranged instead of the heating element. At this time, the solid thermally-conductive material C joined to the joined body b faces an independent and separate solid thermally-conductive material C. That is, a laminate in which the joined body b, the solid thermally-conductive material C, and the heat dissipation part are arranged and laminated in this order is obtained. Next, both the solid thermally-conductive materials C's in the laminate are melted and solidified. At this time, in a state where the solid thermally-conductive material C is melted, a force can be applied and pressed in the solid thermally-conductive material C direction from the heat dissipation part side, from the joined body b side, or from both the heat dissipation part side and the joined body b side, to form a joined body. That is, in a method for producing a joined body including a combination of the b1 process and the c1 process, the heating element can be joined to the heat dissipation part through use of two solid thermally-conductive materials C's.

<<Melting and Solidification>>

A method for melting the solid thermally-conductive material in the a method to the c method includes at least one method selected from the group consisting of contact heating, warm-air heating, hot press, heat-plate welding, infrared-radiation heating, ultrasonic-wave welding, vibration welding, and high-frequency induction welding.

Among these, hot press, ultrasonic-wave welding, and high-frequency induction welding are preferred from the viewpoint of ease of production and shortening of the joining process.

The conditions in the case of performing the hot press are not particularly limited.

The heating temperature in the hot press is preferably 100°C to 400°C, more preferably 120°C to 350°C, and still more preferably 150°C to 300°C. By heating at 100°C to 400°C, the solid thermally-conductive material is efficiently deformed and melted to effectively wet and spread on the joining surface, and therefore a high joining force is obtained.

The applied pressure in the hot press is preferably 0.01 MPa to 20 MPa, more preferably 0.1 MPa to 10 MPa, and still more preferably 0.2 MPa to 5 MPa. When the pressure falls within such a range, the solid thermally-conductive material is efficiently deformed to effectively wet and spread on the joining surface, and therefore a high joining force is obtained.

For example, the joining can be performed by melting and solidifying the solid thermally-conductive material at a heating temperature of 100°C to 400°C under the application of a pressure of 0.01 MPa to 20 MPa.

When at least any one of the group consisting of the heating element A, the heat dissipation part B, the heat dissipation part B2, and the heat dissipation part B3 that are joining objects are a resin, the conditions under which ultrasonic-wave welding is performed are not particularly limited as long as the conditions are conditions under which part of at least one of these resins and the solid thermally-conductive material is melted.

For example, the transmitted frequency is preferably 10 kHz to 70 kHz, and more preferably 15 kHz to 40 kHz.

The ultrasonic application time is preferably 0.1 seconds to 3 seconds, and more preferably 0.2 seconds to 2 seconds from the viewpoint of a joining property and appearance.

When the heating element A and the heat dissipation part B are pressurized or the heat dissipation part B2 and the heat dissipation part B3 are pressurized at the time of ultrasonic application, the applied pressure is preferably 0.01 MPa to 20 MPa, more preferably 0.1 MPa to 10 MPa, and still more preferably 0.2 MPa to 5 MPa. When the pressure falls within such a range, the solid thermally-conductive material is efficiently deformed to effectively wet and spread on the joining surface, and therefore a high joining force is obtained.

When at least any one of the group consisting of the heating element A, the heat dissipation part B2, the heat dissipation part B, and the heat dissipation part B3 that are joining objects are a metal, the conditions under which high-frequency induction welding is performed are not particularly limited as long as the conditions are not conditions under which the metals are melted by heating.

For example, the oscillation frequency falls within the range of 1 kHz to 1,500 kHz. The oscillation frequency may be adjusted to an appropriate one according to the sizes or kinds of the joining objects.

The output falls within the range of 100 W to 5,000 W.

The oscillation time may be adjusted according to the size or kind of at least any one of the group consisting of the heating element A, the heat dissipation part B, and the heat dissipation part B2, and the heat dissipation part B3 that are joining objects, and for example, it is preferably 1.0 second to 10.0 seconds, and more preferably 1.5 seconds to 8.0 seconds.

Examples of a method for solidifying the melted solid thermally-conductive material again include a method in which the solid thermally-conductive material is allowed to cool at normal temperature and a method in which the solid thermally-conductive material is allowed to cool with a cooling device. The term "ordinary temperature" means a general room temperature in the range of 5°C to 30°C. Among these, a method in which the film is allowed to cool at ordinary temperature is preferable from the viewpoint of ease of production.

In this disclosure, the term "solidified" means that the material is solid at ordinary temperature, that is, the material does not have fluidity in a non-pressurized state at 23°C.

The joining in all the a method to the c method is joining utilizing a phase change (from solid to liquid and from liquid to solid) of the solid thermally-conductive material, and is not accompanied by a chemical reaction. Accordingly, the joining can be completed in a shorter time than by a conventional method with a chemical reaction.

<Solid Thermally-conductive Material>

A solid thermally-conductive material used in the joining method according to the present invention contains a thermoplastic resin and a heat dissipation filler, and the content of the thermoplastic resin is 51% by mass or more of a resin component in the solid thermally-conductive material.

In this disclosure, the term "resin component in the solid thermally-conductive material" means a component other than the heat dissipation filler in the solid thermally-conductive material.

The content of the thermoplastic resin is preferably 60% by mass or more, more preferably 70% by mass or more, still more preferably 80% by mass or more, and most preferably 90% by mass or more of the resin component in the solid thermally-conductive material. As the content of the thermoplastic resin is higher, the characteristics of the thermoplastic resin more significantly appear in the solid thermally-conductive material.

Although the thermoplastic resin contained in the solid thermally-conductive material is not limited to a particular thermoplastic resin, the use of an amorphous thermoplastic resin as the thermoplastic resin can impart characteristics of the amorphous thermoplastic resin to the solid thermally-conductive material. The amorphous thermoplastic resin is a resin having a melting point (Tm) but having an endothermic peak associated with melting that is not recognized as a clear endothermic peak or is very low in measurement with a differential scanning calorimeter (DSC).

The amorphous thermoplastic resin is preferably an amorphous thermoplastic resin having a heat of fusion of 15 J/g or less.

The heat of fusion is calculated from the area of the endothermic peak of DSC (differential scanning calorimeter) and the mass of the thermoplastic resin component. When an inorganic filler or the like is contained in the solid thermally-conductive material, the heat of fusion is calculated from the mass of the thermoplastic resin component excluding the inorganic filler. Specifically, 2 mg to 10 mg of a sample is weighed and placed in an aluminum pan, the temperature is raised from 23°C to 200°C or higher at 10°C/min with a DSC (DSC8231, manufactured by Rigaku Corporation) to obtain a DSC curve, and then the heat of fusion can be calculated from the area of the endothermic peak at the time of melting obtained from the DSC curve and the weighed value.

The heat of fusion of the amorphous thermoplastic resin is more preferably 11 J/g or less, further preferably 7 J/g or less, still further preferably 4 J/g or less, and it is most preferable that the melting peak be equal to or lower than the detection limit.

In the solid thermally-conductive material containing an amorphous thermoplastic resin having a heat of fusion of 15 J/g or less in an amount of 51% by mass or more of the resin component in the solid thermally-conductive material, a rapid reduction in viscosity does not occur during heating, and a low viscosity (0.001 to 100 Pa·s) state is not reached even in a high temperature region of higher than 200°C. Therefore, the solid thermally-conductive material does not melt and flow out, the thickness after solidification can be maintained within a predetermined range, a high connecting force can be stably obtained, and pump-out can be avoided.

When the amorphous thermoplastic resin has a melting point, the melting point is preferably 50°C to 400°C, more preferably 60°C to 350°C, and still more preferably 70°C to 300°C. When the melting point falls within the range of 50°C to 400°C, the solid thermally-conductive material is more efficiently deformed and melted by heating, to effectively wet and spread between a heating element and a heat dissipation part or between heat dissipation parts. Therefore, a high connecting force is obtained.

In this disclosure, the melting point of the amorphous thermoplastic resin means a temperature range of a process in which the amorphous thermoplastic resin is substantially softened from a solid state, becomes thermoplastic, and can be melted and joined, and means a melting peak temperature measured with a DSC. When no melting peak is obtained, a temperature obtained by adding 70°C to the glass transition point is defined as the melting point. The glass transition point means a temperature at the start of drop in a DSC curve in a second cycle in which the temperature is raised to 200°C, then cooled to 40°C or lower, and further heated to 200°C with a DSC.

The amorphous thermoplastic resin is preferably at least any one of a thermoplastic epoxy resin and a phenoxy resin. The thermoplastic epoxy resin and the phenoxy resin have a low cohesive force in the resins and a hydroxy group, and therefore have a high interaction with a heating element or a heat dissipation part and can achieve connection with a high connecting force. In addition, since the thermoplastic epoxy resin and the phenoxy resin have excellent flexibility and toughness, a high strength connection can be achieved.

The amorphous thermoplastic resin is preferably an amorphous thermoplastic resin having an epoxy equivalent of 1,600 or more or an amorphous thermoplastic resin having no epoxy group.

The epoxy equivalent (the mass of the thermoplastic resin containing 1 mol of epoxy group) is the value of the epoxy equivalent of the thermoplastic resin contained in the solid thermally-conductive material before incorporation into an electronic device, and is a value measured by a method defined in JIS K 7236:2001 (unit: "g/eq."). Specifically, the epoxy equivalent is a value obtained by adding a brominated tetraethylammonium acetic acid solution using a potentiometric titration device, using a 0.1 mol/L perchloric acid-acetic acid solution, and calculating a numerical value of a solvent diluted product (resin varnish) as a value in terms of a solid content from a nonvolatile component. In the case of a mixture of two or more resins, the epoxy equivalent can also be calculated from the content and the epoxy equivalent of each resin.

The epoxy equivalent of the amorphous thermoplastic resin is more preferably 2,000 or more, further preferably 5,000 or more, and still further preferably 9,000 or more, and it is most preferable that the epoxy equivalent be equal to or higher than the detection limit and the epoxy group be not substantially detected. The expression "the epoxy equivalent is equal to or higher than the detection limit" means that the epoxy group is not detected when the epoxy equivalent is measured based on JIS K 7236:2001 to be described later.

When the solid thermally-conductive material contains the amorphous thermoplastic resin having an epoxy equivalent of 1,600 or more and a heat of fusion of 15 J/g or less in an amount of 51% by mass or more of the resin component in the solid thermally-conductive material, a rapid reduction in viscosity can be more effectively suppressed, and a higher connecting force can be stably obtained.

The solid thermally-conductive material used in the present invention is thermoplastic, and softening and/or melting and curing can be reversibly repeated, and therefore the solid thermally-conductive material can be stored in a solid state before insertion in an electronic device, and can be converted to a liquid state at an insertion portion and then inserted as a solid. Since the solid thermally-conductive material can be stored in a solid state before incorporation into an electronic device, a special technique is not required for storage and incorporation operations, and the solid thermally-conductive material is excellent in suitability for existing production lines. Since the solid thermally-conductive material can be melted at an incorporation portion, conform to irregularities, which are a complicated shape, to come into close contact with the irregularities, and then be solidified, the solid thermally-conductive material has high suitability for various designs. In addition, softening and/or melting and curing can be reversibly repeated, and therefore pump-out does not occur, voids are less liable to be generated, and a reduction in performance due to long-term use and repetition use can be avoided.

<<Thermoplastic Epoxy Resin>>

The thermoplastic epoxy resin is preferably a polymer of (a) a bifunctional epoxy resin monomer or oligomer and (b) a bifunctional compound having two identical or different functional groups selected from the group consisting of a phenolic hydroxy group, a carboxy group, a mercapto group, an isocyanate group, and a cyanate ester group.

By using such a compound, the polymerization reaction for forming a linear polymer preferentially proceeds, and a thermoplastic epoxy resin having desired properties can be obtained.

The bifunctional epoxy resin monomer or oligomer (a) refers to an epoxy resin monomer or oligomer having two epoxy groups in the molecules.

Specific examples of the component (a) include bisphenol A type epoxy resins, bisphenol F type epoxy resins, bifunctional phenol novolac type epoxy resins, bisphenol AD type epoxy resins, biphenyl type epoxy resins, bifunctional

EP 4 640 784 A1

naphthalene type epoxy resins, bifunctional alicyclic epoxy resins, bifunctional glycidyl ester type epoxy resins (e.g., diglycidyl phthalate, diglycidyl tetrahydrophthalate, dimer acid diglycidyl ester), bifunctional glycidylamine type epoxy resins (e.g., diglycidyl aniline, diglycidyl toluidine), bifunctional heterocyclic epoxy resins, bifunctional diarylsulfone type epoxy resins, hydroquinone type epoxy resins (e.g., hydroquinone diglycidyl ether, 2,5-di-tert-butylhydroquinone diglycidyl ether, resorcin diglycidyl ether), bifunctional alkylene glycidyl ether-based compounds (e.g., butanediol diglycidyl ether, butenediol diglycidyl ether, butynediol diglycidyl ether), bifunctional glycidyl group-containing hydantoin compounds (e.g., 1,3-diglycidyl-5,5-dialkylhydantoin, 1-glycidyl-3-(glycidoxyalkyl)-5,5-dialkylhydantoin), bifunctional glycidyl group-containing siloxanes (e.g., 1,3-bis(3-glycidoxypropyl)-1,1,3,3-tetramethyldisiloxane, $\alpha,\beta$-bis(3-glycidoxypropyl) polydimethylsiloxane), and modified products thereof. Among these, a bisphenol A type epoxy resin, a bisphenol F type epoxy resin, and a biphenyl type epoxy resin are preferred from the viewpoint of reactivity and workability.

Examples of the bifunctional compound having a phenolic hydroxy group of the component (b) include mononuclear aromatic dihydroxy compounds having one benzene ring, such as catechol, resorcin, and hydroquinone; bisphenols such as bis(4-hydroxyphenyl)propane (bisphenol A), bis(4-hydroxyphenyl)methane (bisphenol F), and bis(4-hydroxyphenyl)ethane (bisphenol AD); compounds having a condensed ring such as dihydroxynaphthalene; bifunctional phenol compounds into which an allyl group is introduced, such as diallyl resorcin, diallyl bisphenol A, and triallyl dihydroxybiphenyl; and dibutyl bisphenol A.

Specific examples of the carboxyl group-containing compound of the component (b) include adipic acid, succinic acid, malonic acid, cyclohexanedicarboxylic acid, phthalic acid, isophthalic acid, and terephthalic acid.

Examples of the mercapto group-containing bifunctional compound of the component (b) include ethylene glycol bisthioglycolate and ethylene glycol bisthiopropionate.

Specific examples of the bifunctional compound having an isocyanate group of the component (b) include diphenylmethane diisocyanate (MDI), isophorone diisocyanate (IPDI), hexamethylene diisocyanate (HMDI), and tolylene diisocyanate (TDI).

Specific examples of the cyanate ester group-containing bifunctional compound of the component (b) include 2,2-bis(4-cyanatophenyl)propane, 1,1-bis(4-cyanatophenyl)ethane, and bis(4-cyanatophenyl)methane.

Among the compounds of the component (b), a bifunctional compound having a phenolic hydroxy group is preferred from the viewpoint of obtaining a polymer having thermoplasticity, a bifunctional compound having two phenolic hydroxy groups and having a bisphenol structure or a biphenyl structure is preferred from the viewpoint of heat resistance and a joining property, and bisphenol A, bisphenol F, or bisphenol S is preferred from the viewpoint of heat resistance and cost.

When the component (a) is a bisphenol A type epoxy resin, a bisphenol F type epoxy resin, a bisphenol S type epoxy resin, or a biphenyl type epoxy resin and the component (b) is bisphenol A, bisphenol F, or bisphenol S, the polymer obtained by polymerization of the component (a) and the component (b) has a structure in which a para-phenylene structure and an ether bond are used as a main skeleton, a main chain formed by connecting them with an alkylene group, and a hydroxy group generated by polyaddition are arranged in a side chain.

The linear structure composed of the para-phenylene skeleton can increase the mechanical strength of the polymer after polymerization, and the arranged hydroxy group in the side chain can improve the adhesion. As a result, high joining strength can be realized while maintaining the workability of the thermosetting resin.

<<Phenoxy Resin>>

The phenoxy resin is a polyhydroxy polyether synthesized from bisphenols and epichlorohydrin, and has thermoplasticity. For the production of the phenoxy resin, a method by a direct reaction of a dihydric phenol and epichlorohydrin, and a method by an addition polymerization reaction of a diglycidyl ether of a dihydric phenol and a dihydric phenol are known, and the phenoxy resin used in the present invention may be obtained by any production method. In the case of a direct reaction between a dihydric phenol and epichlorohydrin, examples of the dihydric phenol include phenols such as bisphenol A, bisphenol F, bisphenol S, biphenol, biphenylene diol, and fluorene diphenyl; and aliphatic glycols such as ethylene glycol, propylene glycol, and diethylene glycol. Among these, bisphenol A, bisphenol F, and bisphenol S are preferred from the viewpoint of cost, a joining property, viscosity, and heat resistance. These may be used alone, or two or more kinds thereof may be used in combination.

The phenoxy resin has a chemical structure similar to that of an epoxy resin and has a structure in which a para-phenylene structure and an ether bond are used as a main skeleton, a main chain is formed by connecting them, and a hydroxy group is disposed in a side chain.

<<Weight-average Molecular Weights of Thermoplastic Epoxy Resin and Phenoxy Resin>>

The thermoplastic epoxy resin and the phenoxy resin preferably have a weight-average molecular weight of 10,000 to 500,000, more preferably 18,000 to 300,000, and still more preferably 20,000 to 200,000, which is a value in terms of polystyrene as measured by gel permeation chromatography (GPC). The weight-average molecular weight is calculated from an elution peak position detected by GPC, and is a value of a molecular weight in terms of standard polystyrene. When the weight-average molecular weight falls within this value range, the balance between thermoplasticity and heat resistance is good, and the heat resistance thereof is also high. When the weight-average molecular weight is 10,000 or more, the heat resistance is excellent, and when the weight-average molecular weight is 500,000 or less, the viscosity at the time of melting is low, and the joining property is high.

<<Method for Producing Solid Thermally-conductive Material>>

A method for producing the solid thermally-conductive material is not particularly limited, but the solid thermally-conductive material is obtained, for example, by heating a composition in which a heat dissipation filler is added to a monomer or oligomer of a bifunctional epoxy compound, followed by polymerization. During the polymerization, a solvent may be added to reduce the viscosity and facilitate stirring. When a solvent is added, the removal of the solvent is required, and drying or polymerization or both may be performed on a release film or the like to obtain the solid thermally-conductive material.

The kind of a heat dissipation filler is not particularly limited, but examples thereof include metal-containing particles and non-metal particles each having an excellent thermally-conductive property. Further examples thereof include metal particles, resin particles plated with gold or the like, and gold-plated resin particles having an insulation-covering outermost layer.

The heat dissipation filler may be, for example, a filler having a thermal conductivity of 10 W/(m·K) or more. The heat dissipation filler may have an insulating property or a conductive property.

Examples of the heat dissipation filler include metal, metal oxide, metal nitride, metal hydroxide, metal carbide, metal fluoride, and carbon. One kind of the heat dissipation filler may be used, or two or more kinds thereof may be used in combination. Specific examples thereof include aluminum, copper, silver, magnesium oxide, aluminum oxide, zinc oxide, iron oxide, silicon dioxide, beryllium oxide, tin oxide, boron nitride, aluminum nitride, silicon nitride, magnesium hydroxide, aluminum hydroxide, boron carbide, silicon carbide, aluminum fluoride, calcium fluoride, carbon black, carbon nanofiber, carbon nanotube, diamond, fullerene, and graphite.

Among these, from the viewpoint of a thermally-conductive property, chemical stability availability, and the like one kind or two or more kinds selected from silver, aluminum oxide, magnesium oxide, aluminum hydroxide, magnesium hydroxide, aluminum nitride, boron nitride, silicon dioxide, carbon black, carbon nanofiber, carbon nanotube, silicon carbide, silicon nitride are preferably used.

The average particle diameter of the heat dissipation filler is not particularly limited, but may be 0.1 $\mu$m to 50 $\mu$m, 0.2 $\mu$m to 20 $\mu$m, or 0.5 $\mu$m to 10 $\mu$m. When the average particle diameter falls within the aforementioned range, the packing density of the heat dissipation filler can be increased. As the packing density is higher, the contact point of the heat dissipation filler is increased, and therefore the thermal conductivity can be improved.

In order to increase the packing rate, two or more kinds of heat dissipation fillers having different average particle diameters may be contained.

The average particle diameter can be expressed through use of a volume standard D50. When a mass cumulative particle size distribution curve is drawn from a small particle diameter size, the volume standard D50 corresponds to the particle diameter in which the mass accumulation is 50%. D50 can be measured by a Coulter counter method, a laser diffraction-scattering method (e.g., "Microtrac series MT3300" manufactured by Nikkiso Co., Ltd.), or the like. For example, in the case of spherical alumina particles, D50 is preferably measured by a Coulter counter method, and in the case of scale-like hexagonal boron nitride particles, D50 is preferably measured by a laser diffraction-scattering method.

Various shapes such as spherical, plate-like, polygonal, granular, and fibrous shapes can be adopted as the shape of the heat dissipation filler.

When the heat dissipation filler having anisotropy is used, the strength and thermally-conductive property of the resin composition in a predetermined direction can be improved by appropriately controlling the orientation in the composition.

The content of the heat dissipation filler may be 30% by volume to 95% by volume, preferably 40% by volume to 95% by volume, more preferably 50% by volume to 90% by volume, and particularly preferably 60% by volume to 80% by volume.

The content (% by volume) of the heat dissipation filler is determined from the charged amount at 25°C, and is calculated by the following (Formula 1) based on the specific gravity of the components other than the filler and the true specific gravity of the filler with respect to the mass percentage of the filler.

(Formula 1)

$$X = (MF/DF) \div (MF/DF + (100 - MF)/DR) \times 100\%$$

In (Formula 1),

> X: the content (% by volume) of the heat dissipation filler,
> MF: the charged amount (% by mass) of the heat dissipation filler,
> DR: the specific gravity at the time of curing the resin component, and
> DF: the true specific gravity of the heat dissipation filler.

The content (% by volume) of the heat dissipation filler is specifically calculated by the following procedure.

(Procedure 1) The specific gravity (DR) of the whole of the solid thermally-conductive material is measured with a hydrometer.

(Procedure 2) The mass of the solid thermally-conductive material is measured, the resin component of the solid thermally-conductive material is dissolved in an appropriate organic solvent, and the heat dissipation filler is separated by filtration or centrifugal separation.

(Procedure 3) The heat dissipation filler separated in Procedure 2 is dried, and the mass thereof is then measured.

(Procedure 4) The component and crystal structure of the heat dissipation filler are specified from a XRD pattern, and the specific gravity of the pure crystal of the heat dissipation filler (true specific gravity: DF) is obtained. In the analysis of the crystal structure, a known method such as Rietveld analysis can be used.

(Procedure 5) The content of the heat dissipation filler (% by mass: MF) is calculated from the mass of the solid thermally-conductive material measured in Procedure 2 and the mass of the heat dissipation filler measured in Procedure 3.

(Procedure 6) The volume percentage "X" is calculated by (Formula 1) from "DR" in Procedure 1, "DF" in Procedure 4, and "MF" in Procedure 5, as described above.

When the content of the heat dissipation filler is 30% by volume or more, the packing density of the heat dissipation filler can be increased. As the packing density is higher, the contact point of the heat dissipation filler is increased, and therefore the thermal conductivity is improved.

The solid thermally-conductive material in which the content of the heat dissipation filler is 95% by volume or less has satisfactory moldability, and can be easily molded in a sheet shape. When the content of the heat dissipation filler is 95% by volume or less, a high joining force is obtained.

The total content of the resin component and the heat dissipation filler in the solid thermally-conductive material is preferably 70% by volume or more, more preferably 85% by volume or more, and particularly preferably 95% by volume.

The total content of the amorphous thermoplastic resin and the heat dissipation filler in the solid thermally-conductive material is preferably 70% by volume or more, more preferably 80% by volume or more, and particularly preferably 90% by volume.

In addition to the heat dissipation filler, the solid thermally-conductive material may contain an additional additive as required as long as the object of the present invention is not impaired. The blending amount of the additional additive with respect to the whole amount of the thermoplastic resin is preferably 50% by volume or less, more preferably 30% by volume or less, still more preferably 20% by volume or less, and most preferably 10% by volume or less. The volume percentage of the additive represents the volume ratio of the volume of the additive contained before the polymerization of the solid thermally-conductive material based on the volume of the whole amount of the thermoplastic resin. The volume of the additive can be determined by dividing the mass of the contained additive by the true specific gravity of the additive.

Examples of the additional additive include a viscosity modifier, an inorganic filler, an organic filler (resin powder), an antifoaming agent, a coupling agent such as a silane coupling agent, and a pigment, and one kind of the additional additive may be used alone, or two or more kinds thereof may be used in combination.

As the viscosity modifier, for example, a reactive diluent or the like may be used.

Herein, the inorganic filler is an inorganic filler that is not included in the heat dissipation filler having an excellent thermally-conductive property, and is used for enhancement in strength or the like. Examples thereof include spherical fused silica, silica sand, talc, calcium carbonate, mica, acid clay, diatomaceous earth, kaolin, quartz, titanium oxide, silica, and glass balloons.

The solid thermally-conductive material thus obtained has excellent storage stability, can be stored at normal temperature for a long period of time, and has high suitability for existing production lines because the content of unreacted monomers and terminal epoxy groups is small or substantially zero.

The form of the solid thermally-conductive material is not particularly limited, but preferably has any shape selected from the group consisting of a film, a rod, a pellet, and a powder. In particular, at least one side of the outer shape is preferably 5 mm or less, more preferably 3 mm or less, still more preferably 1 mm or less, even more preferably 0.5 mm or less, and most preferably 0.3 mm or less. When the size falls within such a range, the solid thermally-conductive material can efficiently spread on the joining surface by heating and pressurization, and a high joining force can be obtained.

The solid thermally-conductive material may have tackiness within a range that does not impair the joining force and the heat resistance thereof.

Examples

Next, specific examples of the present invention will be described, but the present invention is not particularly limited to these Examples.

<Substrate>

The following substrates were used.

<<Substrate A>>
Aluminum (A6061, 25 mm × 100 mm × 1.6 mm in thickness; degreased by wiping a surface with methyl ethyl ketone
<<Substrate B>>
Aluminum (A6061, 25 mm × 100 mm × 1.6 mm in thickness; degreased by wiping a surface with methyl ethyl ketone)
<<Substrate C>>
Copper (C1100, 25 mm × 100 mm × 1.6 mm in thickness; degreased by wiping a surface with methyl ethyl ketone))

<Weight-average Molecular Weight of Base Resin Used in Production of Solid Thermally-conductive Material>

The weight-average molecular weight, heat of fusion, glass transition point, melting point, and epoxy equivalent of a base resin used in production of a solid thermally-conductive material were each determined as described below.

(Weight-average molecular weight)

The base resin was dissolved in tetrahydrofuran, and the weight-average molecular weight was measured under the following conditions with Prominence 501 (manufactured by Showa Science Co., Ltd., Detector: Shodex (registered trademark) RI-501 (manufactured by Showa Denko K.K.)).

Column: LF-804 manufactured by Showa Denko K.K. × 2
Column temperature: 40°C
Sample: 0.4% by mass tetrahydrofuran solution of resin
Flow rate: 1 mL/min
Eluent: tetrahydrofuran
Calibration method: standard polystyrene conversion

(Heat of Fusion and Melting Point)

2 mg to 10 mg of the base resin was weighed and placed in an aluminum pan, and the temperature was raised from 23°C to 200°C at 10°C/min with a DSC (DSC8231, manufactured by Rigaku Corporation) to obtain a DSC curve. The heat of fusion was calculated from the area of the endothermic peak at the time of melting of the DSC curve and the weighed value. The peak temperature at the time of melting was referred to as melting point. When a melting peak is not obtained or when the heat of fusion is 15 J/g or less, a temperature obtained by adding 70°C to the glass transition point is defined as melting point.

(Glass Transition Point Tg)

A temperature at the start of the drop in a DSC curve in a second cycle in which the temperature was raised to 200°C, then cooled to 40°C or lower, and then heated to 200°C with the DSC was defined as glass transition point.

(Epoxy Equivalent)

The epoxy equivalent was measured in accordance with JIS K-7236:2001 and converted into a value as a resin solid content. In the case of a simple mixture that does not involve a reaction, the epoxy equivalent was calculated from each epoxy equivalent and content.

<Example 1>

PhenoTohto (registered trademark) YP-007A30 (manufactured by NIPPON STEEL Chemical & Material CO., LTD., solution of phenoxy resin in cyclohexanone, solid content: 30% by mass) and spherical alumina CB-A20S (manufactured by Showa Denko K.K., average particle diameter d50 = 21 $\mu$m) were mixed at a composition shown in Table 1 in a planetary centrifugal mixer, to obtain a pasty resin composition. The volume percentage of the filler ("filler amount (% by volume)" in Table 1-1) was calculated from a charged amount at 25°C. Specifically, the volume percentage was calculated from the (Formula 1) on the basis of the specific gravity of a component other than the filler and the true specific gravity of the filler with respect to the mass percentage of the filler.

The pasty resin composition was applied to a release treatment PET film with a bar coater, and dried at 160°C for 2 hours, and the film was then passed through a heat roller at 180°C 20 times, to push out air in the coating film. Thus, a film-shaped solid thermally-conductive material sample (hereinafter referred to as SP)1 was obtained.

The solid thermally-conductive material SP1 cut into a size of 25 mm × 12.5 mm was disposed between the substrate A (aluminum having a size of 25 mm × 100 mm × 1.6 mm) and the substrate B (aluminum having a size of 25 mm × 100 mm × 1.6 mm), and the solid thermally-conductive material SP1 was melted under the application of a pressure of 3 MPa with a hot press at 200°C for 10 minutes, and then depressurized and allowed to cool, to be solidified. Thus, a joined body was produced.

<Example 2>

A film-shaped solid thermally-conductive material SP2 was obtained in the same manner as in Example 1 except that the composition of PhenoTohto (registered trademark) YP-007A30 (manufactured by NIPPON STEEL Chemical & Material CO., LTD., solution of phenoxy resin in cyclohexanone, solid content: 30% by mass) and spherical alumina CB-A20S was changed as shown in Table 1.

The solid thermally-conductive material SP2 cut into a size of 25 mm × 12.5 mm was brought into surface contact with the substrate A (aluminum having a size of 25 mm × 100 mm × 1.6 mm), and the solid thermally-conductive material SP2 was melted under the application of a pressure of 3 MPa with a hot press at 200°C for 10 minutes, and then depressurized and allowed to cool, to be solidified. Thus, the solid thermally-conductive material SP2 was joined to the substrate A. After that, the solid thermally-conductive material SP2 in a state where the solid thermally-conductive material was joined to the substrate A was brought into surface contact with the substrate C (copper having a size of 25 mm × 100 mm × 1.6 mm), and the solid thermally-conductive material SP2 was melted under the application of a pressure of 3 MPa with a hot press at 200°C for 10 minutes, and then depressurized and allowed to cool, to be solidified. Thus, a joined body was produced.

<Example 3>

A film-shaped solid thermally-conductive material SP3 was obtained in the same manner as in Example 1 except that the composition of PhenoTohto (registered trademark) YP-007A30 (manufactured by NIPPON STEEL Chemical & Material CO., LTD., solution of phenoxy resin in cyclohexanone, solid content: 30% by mass) and spherical alumina CB-A20S was changed as shown in Table 1.

The solid thermally-conductive material SP3 cut into a size of 25 mm × 12.5 mm was brought into surface contact with the substrate C (copper having a size of 25 mm × 100 mm × 1.6 mm), and the solid thermally-conductive material SP3 was melted under the application of a pressure of 3 MPa with a hot press at 200°C for 10 minutes, and then depressurized and allowed to cool, to be solidified. Thus, the solid thermally-conductive material SP3 was joined to the substrate C. After that, the solid thermally-conductive material SP3 in a state where the solid thermally-conductive material was joined to the substrate C was brought into surface contact with the substrate A (aluminum having a size of 25 mm × 100 mm × 1.6 mm), and the solid thermally-conductive material SP3 was melted under the application of a pressure of 3 MPa with a hot press at 200°C for 10 minutes, and then depressurized and allowed to cool, to be solidified. Thus, a joined body was produced.

<Example 4>

A film-shaped solid thermally-conductive material SP4 was obtained in the same manner as in Example 1 except that the composition of PhenoTohto (registered trademark) YP-007A30 (manufactured by NIPPON STEEL Chemical & Material CO., LTD., solution of phenoxy resin in cyclohexanone, solid content: 30% by mass) and spherical alumina CB-A20S was changed as shown in Table 1.

A joined body was produced in the same manner as in Example 1 except that the solid thermally-conductive material SP4 cut into a size of 25 mm $\times$ 12.5 mm was disposed between the substrates A and B.

<Example 5>

A film-shaped solid thermally-conductive material SP5 was obtained in the same manner as in Example 1 except that the composition of PhenoTohto (registered trademark) YP-007A30 (manufactured by NIPPON STEEL Chemical & Material CO., LTD., solution of phenoxy resin in cyclohexanone, solid content: 30% by mass) and spherical alumina CB-A20S was changed as shown in Table 1.
A joined body was produced in the same manner as in Example 1 except that the solid thermally-conductive material SP5 cut into a size of 25 mm $\times$ 12.5 mm was disposed between the substrates A and B.

<Example 6>

A film-shaped solid thermally-conductive material SP6 was obtained in the same manner as in Example 1 except for use, as a base resin solution, of a resin solution having a solid content of 20% by mass that was obtained by placing 20 g of PhenoTohto (registered trademark) YP-50S (manufactured by NIPPON STEEL Chemical & Material CO., LTD., phenoxy resin, weight-average molecular weight: about 50,000) and 80 g of cyclohexanone in a reactor equipped with a stirrer, a reflux condenser, a gas inlet tube, and a thermometer, raising the temperature to 60°C with stirring, visually recognizing dissolution, and reducing the temperature to 40°C.
A joined body was produced in the same manner as in Example 1 except that the solid thermally-conductive material SP6 cut into a size of 25 mm $\times$ 12.5 mm was disposed between the substrates A and B.

<Example 7>

A reactor equipped with a stirrer, a reflux condenser, a gas introduction tube, and a thermometer was charged with 1.0 equivalent (203 g) of jER (registered trademark) 1007 (manufactured by Mitsubishi Chemical Corporation, bisphenol A type epoxy resin, weight-average molecular weight: about 11,000), 1.0 equivalent (12.5 g) of bisphenol S, 2.4 g of triphenylphosphine, and 1,000 g of cyclohexanone, and the temperature was raised to 100°C with stirring in a nitrogen gas atmosphere. A film-shaped solid thermally-conductive material SP7 was obtained in the same manner as in Example 1 except for use, as a base resin solution, of a resin solution having a solid content of 20% by mass that was obtained by visually recognizing dissolution, raising the temperature to 170°C, causing a reaction at 170°C for 6.5 hours, and reducing the temperature to 40°C.
A joined body was produced in the same manner as in Example 1 except that the solid thermally-conductive material SP7 cut into a size of 25 mm $\times$ 12.5 mm was disposed between the substrates A and B.

<Example 8>

A reactor equipped with a stirrer, a reflux condenser, a gas introduction tube, and a thermometer was charged with 1.0 equivalent (203 g) of jER (registered trademark) 1007 (manufactured by Mitsubishi Chemical Corporation, bisphenol A type epoxy resin, weight-average molecular weight: about 11,000), 1.0 equivalent (12.5 g) of bisphenol S, 2.4 g of triphenylphosphine, and 1,000 g of cyclohexanone, and the temperature was raised to 100°C with stirring in a nitrogen gas atmosphere. Dissolution was visually recognized, and the mixture was cooled to 40°C to obtain a base resin solution having a solid content of 20% by mass. The base resin solution and spherical alumina CB-A20S (manufactured by Showa Denko K.K., average particle diameter d50 = 21 $\mu$m) were mixed at a composition shown in Table 1 in a planetary centrifugal mixer, to obtain a paste. The paste was applied to a release treatment PET film with a bar coater, and heated at 160°C for 2 hours to dry the solvent and polymerize an epoxy resin and bisphenol S. Subsequently, the film was passed through a heat roller at 180°C 20 times, to push out air in the coating film. Thus, a film-shaped solid thermally-conductive material SP8 was obtained.
A joined body was produced in the same manner as in Example 1 except that the solid thermally-conductive material SP8 cut into a size of 25 mm $\times$ 12.5 mm was disposed between the substrates A and B.

<Example 9>

A reactor equipped with a stirrer, a reflux condenser, a gas introduction tube, and a thermometer was charged with 203 g of jER (registered trademark) 1007 (manufactured by Mitsubishi Chemical Corporation, bisphenol A type epoxy resin, weight-average molecular weight: about 11,000), and 1,000 g of cyclohexanone, and the temperature was raised to 100°C with stirring in a nitrogen gas atmosphere. A film-shaped solid thermally-conductive material SP9 was obtained in the same manner as in Example 1 except for use, as a base resin solution, of a base resin solution having a solid content of 20% by mass that was obtained by visually recognizing dissolution and reducing the temperature to 40°C.

A joined body was produced in the same manner as in Example 1 except that the solid thermally-conductive material SP9 cut into a size of 25 mm × 12.5 mm was disposed between the substrates A and B.

<Example 10>

A crystalline epoxy resin YSLV-80XY (manufactured by NIPPON STEEL Chemical & Material CO., LTD.) was ground and uniformly sprinkled on the film (solid thermally-conductive material SP3) of Example 3 until the alumina amount was 65% by mass, the film was pressed with a vice, and heated to 50°C to obtain a film-shaped solid thermally-conductive material SP10. A joined body was produced in the same manner as in Example 1 except that the solid thermally-conductive material SP10 cut into a size of 25 mm × 12.5 mm was disposed between the substrates A and B.

<Example 11>

A reactor equipped with a stirrer, a reflux condenser, a gas introduction tube, and a thermometer was charged with 1.0 equivalent (203 g) of jER (registered trademark) 1007 (manufactured by Mitsubishi Chemical Corporation, bisphenol A type epoxy resin, weight-average molecular weight: about 11,000), 1.0 equivalent (12.5 g) of bisphenol S, 2.4 g of triphenylphosphine, and 1,000 g of cyclohexanone, and the temperature was raised to 100°C with stirring in a nitrogen gas atmosphere. Dissolution was visually recognized, and the mixture was cooled to 40°C to obtain a base resin solution having a solid content of 20% by mass. The base resin solution and silver particles (particle diameter: 1.5 $\mu$m) were mixed at a composition of Table 1, to obtain a resin composition. The resin composition was applied to a release treatment PET film with a bar coater, and heated at 160°C for 2 hours to dry the solvent and polymerize an epoxy resin and bisphenol S. Subsequently, the film was passed through a heat roller at 180°C 20 times, to push out air in the coating film. Thus, a film-shaped solid thermally-conductive material SP11 was obtained. A joined body was produced in the same manner as in Example 1 except that the solid thermally-conductive material SP11 cut into a size of 25 mm × 12.5 mm was disposed between the substrates A and B.

<Example 12>

A film-shaped solid thermally-conductive material SP12 was obtained in the same manner as in Example 1 except for use of a resin composition obtained by mixing 57 parts by mass of a pasty resin composition obtained by mixing YP-007A30 with spherical alumina CB-A20S in the same manner as in Example 1 with 43 parts by mass of a pasty resin composition in which a 25% by mass resin solution in which a polyamide-based crystalline hot-melt adhesive TY-863H1 was dissolved in THF was mixed with the spherical alumina CB-A20S so that the content of the spherical alumina CB-A20S was 64% by volume in a planetary centrifugal mixer. A joined body was produced in the same manner as in Example 1 except that the solid thermally-conductive material SP12 cut into a size of 25 mm × 12.5 mm was disposed between the substrates A and B.

<Example 13>

A film-shaped solid thermally-conductive material SP13 was obtained in the same manner as in Example 7 except for use of jER1004 (manufactured by Mitsubishi Chemical Corporation, bisphenol A type epoxy resin, weight-average molecular weight: about 5,000) instead of jER1007.

A joined body was produced in the same manner as in Example 1 except that the solid thermally-conductive material SP13 cut into a size of 25 mm × 12.5 mm was disposed between the substrates A and B.

<Example 14>

A film-shaped solid thermally-conductive material SP14 was obtained in the same manner as in Example 1 except for use, as a base resin solution, of a 25% by mass resin solution in which a polyamide-based crystalline hot-melt adhesive TY-863H1 was dissolved in THF.

A joined body was produced in the same manner as in Example 1 except that the solid thermally-conductive material CSP1 cut into a size of 25 mm × 12.5 mm was disposed between the substrates A and B.

<Comparative Example 1>

Spherical alumina CB-A20S (manufactured by Showa Denko K.K., average particle diameter d50 = 21 $\mu$m) was added to crystalline epoxy resin YSLV-80XY (manufactured by NIPPON STEEL Chemical & Material CO., LTD.) so that the content of the spherical alumina was 46% by volume, and mixed in a planetary centrifugal mixer, to obtain a paste. The paste was disposed between releasing treatment PET films, and the films were pressed to obtain a comparison sample of a film-shaped solid thermally-conductive material (hereinafter also referred to as CSP) 1.

A joined body was produced in the same manner as in Example 1 except that the solid thermally-conductive material CSP2 cut into a size of 25 mm × 12.5 mm was disposed between the substrates A and B.

<Comparative Example 2>

100 g of epoxy resin jER1007, 6.2 g of bisphenol S, and 0.4 g of triethylamine were dissolved in 197 g of acetone, to obtain a composition (A1).

100 g of epoxy resin NC-3000 having a biphenyl skeleton, 91.9 g of phenol compound TAM-005 having an imidazolidinone skeleton, and 1.54 g of triethylamine were dissolved in 356.5 g of acetone, to obtain a composition (B2).

A film-shaped solid thermally-conductive material CSP2 was obtained in the same manner as in Example 1 except that a resin composition in which the composition (A1) and the composition (B1) were blended at a mass ratio except acetone of 40/60 was used and the composition of spherical alumina CB-A20S was changed as shown in Table 1. A joined body was produced in the same manner as in Example 1 except that the solid thermally-conductive material CSP2 cut into a size of 25 mm × 12.5 mm was disposed between the substrates A and B.

<Comparative Example 3>

A comparison film-shaped solid thermally-conductive material CSP3 was obtained in the same manner as in Example 1 except that spherical alumina CB-A20S was not mixed.

A joined body was produced in the same manner as in Example 1 except that the solid thermally-conductive material CSP3 cut into a size of 25 mm × 12.5 mm was disposed between the substrates A and B.

[Thermal Conductivity]

The thermal conductivities of the solid thermally-conductive materials obtained in Examples 1 to 14 and Comparative Examples 1 to 3 were evaluated using the following Formula by a laser flush method. The evaluation results are shown in Table 1-1 and Table 1-2.

In the Formula, the "thermal diffusivity", "specific heat capacity", and "density" were each determined by the following methods.

Thermal diffusivity: A flat plate of a thermally-conductive resin composition was cut out into a disc having a diameter of 10 mm, and the thermal diffusivity in the thickness direction

$$\text{Thermal conductivity} = \text{thermal diffusivity} \times \text{specific heat capacity} \times \text{density}$$

of the disc was measured at 20°C with Laser flash TC-7000 (manufactured by Shinku-rika).

Specific heat capacity: The specific heat capacity of powder of a thermally-conductive resin composition was measured with a differential scanning calorimeter DSC7 (manufactured by Perkin Elmer) in accordance with JIS K 7123:1987. Specifically, an aluminum pan was filled with about 10 mg of the thermally-conductive resin composition. The sample pan and an empty pan were set in a holder. The temperature was held at 0°C for 15 minutes, and then raised to 50°C at a temperature rising rate of 10°C/min, to obtain a DSC curve of the thermally-conductive resin composition. A DSC curve of about 10 mg of $\alpha$-alumina as a standard substance was obtained by a similar temperature profile. The specific heat capacity of the thermally-conductive resin composition was evaluated from the DSC curves of the thermally-conductive resin composition and $\alpha$-alumina.

Density: A specimen of 50 mm × 50 mm was cut from a flat plate of the thermally-conductive resin composition, and subjected to measurement with DENSI METER (manufactured by Toyo Seiki Kogyo Co., Ltd.) in accordance with JIS K 7112:1999.

[Shear Joining Force]

The joined bodies obtained in Examples 1 to 14 and Comparative Examples 1 to 3 were used, and allowed to stand at a measurement temperature (23°C or 80°C) for 30 minutes or more, and a tensile shear joining force test was performed in 23°C and 80°C atmospheres using a tensile testing machine (autograph universal testing machine "AG-X plus" (manufactured by Shimadzu Corporation); load cell: 10 kN, tensile speed: 10 mm/min) in accordance with ISO19095 to measure the joining strength. The measurement results are shown in Table 1-1 and Table 1-2.

[Adhesion to Irregularities]

After the shear joining force test of each of the joined bodies obtained in Examples 1 to 14 and Comparative Examples 1 to 3, the joining surface was observed. When there were no portions where the joined body was not brought into close contact with the substrate, the adhesion to irregularities was evaluated as satisfactory (good), and when there was a portion where the joined body was not brought into close contact with the substrate, the adhesion to irregularities was evaluated as unsatisfactory (poor). The evaluation results are shown in Table 1-1 and Table 1-2.

[Joining Process Time]

The joining process time was measured as follows.
The joining process time was measured from a start point to an end point, with the contact time between at least one of the substrates constituting the joined body and a bonding agent as the start point and the completion time of the production of the joined body as the end point. With respect to the heating and pressurization time, the heating and pressurization times of three kinds of joined bodies were averaged. The measurement results are shown in Table 1-1 and Table 1-2.

[Recycling Property]

The recycling property was determined by placing the joined body on a hot plate at 200°C, heating the joined body for 1 minute, and then determining whether or not the joined body could be easily peeled with a force of 1 N or less. When the joined body could be peeled, the recycling property was evaluated as satisfactory (good), and when the joined body could not be peeled, the recycling property was evaluated as unsatisfactory (poor). The evaluation results are shown in Table 1-1 and Table 1-2.

[Repairing Property]

After the test of the shear joining force in a 23°C atmosphere, the substrate A was arranged on the substrate B of specimens having a ruptured joining surface (a joined solid layer remained on the surface of the substrate A or B or the surfaces of both the substrates), and a joined body was prepared in the same manner as in Example 1, to obtain a repaired joined body. The shear joining force at 23°C of the repaired joined body was measured in the same manner as the method of the above-mentioned test. When the shear joining force of the first time was 80% or more, the repairing property was evaluated as satisfactory (good), and when it was less than 80%, the repairing property was evaluated as unsatisfactory (poor). The evaluation results are shown in Table 1-1 and Table 1-2.

[Open Time Evaluation]

Using the joined body for open time evaluation, the tensile shear joining strength test was performed at 23°C. When the shear joining force was 80% or more in comparison with the specimens prepared by the methods in Examples and Comparative Examples, the open time evaluation was evaluated as satisfactory (good), and when it was less than 80%, the open time evaluation was evaluated as unsatisfactory (poor). The open time evaluation that is evaluated as satisfactory (good) means that the open time is long and excellent convenience is achieved.

[Table 1-1]

Table 1-1

| | | | | Example 1 | Example 2 | Example 3 | Example 4 |
|---|---|---|---|---|---|---|---|
| Composition | Substrate A | Kind | - | Aluminum | Aluminum | Aluminum | Aluminum |
| | Substrate B | Kind | - | Aluminum | - | - | Aluminum |
| | Substrate C | Kind | - | - | Copper | Copper | - |
| | Joining method | | | c method | a method | b method | c method |
| | Base resin | No | | L-1 | L-1 | L-1 | L-1 |
| | | Kind | - | Phenoxy resin | Phenoxy resin | Phenoxy resin | Phenoxy resin |
| | | Weight-average molecular weight | - | 50000 | 50000 | 50000 | 50000 |
| | | Heat of fusion | J/g | No melting peak | No melting peak | No melting peak | No melting peak |
| | | Tg | °C | 123 | 123 | 123 | 123 |
| | | Melting point | °C | 193 | 193 | 193 | 193 |
| | | Epoxy equivalent | g/eq | Equal to or higher than detection limit | Equal to or higher than detection limit | Equal to or higher than detection limit | Equal to or higher than detection limit |
| | Heat dissipation filler | | - | Alumina | Alumina | Alumina | Alumina |
| | Heat dissipation filler content | | % by volume | 46 | 65 | 65 | 65 |
| Evaluation | Thermal conduction | Thermal conductivity | W/m·K | 1.3 | 2.9 | 2.9 | 2.9 |
| | Bonding force | Shear joining force at 23°C | MPa | 2 | 2 | 2 | 2 |
| | | Shear joining force at 80°C | MPa | 2 | 2 | 2 | 2 |
| | Adhesion to irregularities | | - | Good | Good | Good | Good |
| | Convenience | Joining process time | - | 2 min | 2 min | 2 min | 2 min |
| | | Recycling property | - | Good | Good | Good | Good |
| | | Repairing property | - | Good | Good | Good | Good |
| | | Open time evaluation | - | Good | Good | Good | Good |

Table 1-1 (continued)

| | | | | Example 5 | Example 6 | Example 7 | Example 8 |
|---|---|---|---|---|---|---|---|
| Composition | | Substrate A | Kind | - | Aluminum | Aluminum | Aluminum | Aluminum |
| | | Substrate B | Kind | - | Aluminum | Aluminum | Aluminum | Aluminum |
| | | Substrate C | Kind | - | - | - | - | - |
| | | Joining method | | | c method | c method | c method | c method |
| | | Base resin | No | | L-1 | L-2 | L-3 | L-3 |
| | | | Kind | - | Phenoxy resin | Phenoxy resin | Thermoplastic epoxy resin | Thermoplastic epoxy resin |
| | | | Weight-average molecular weight | - | 50000 | 42000 | 37000 | 32000 |
| | | | Heat of fusion | J/g | No melting peak | No melting peak | No melting peak | No melting peak |
| | | | Tg | °C | 123 | 90 | 101 | 100 |
| | | | Melting point | °C | 193 | 160 | 171 | 170 |
| | | | Epoxy equivalent | g/eq | Equal to or higher than detection limit | Equal to or higher than detection limit | Equal to or higher than detection limit | Equal to or higher than detection limit |
| | | Heat dissipation filler | | - | Alumina | Alumina | Alumina | Alumina |
| | | Heat dissipation filler content | | % by volume | 73 | 46 | 46 | 46 |
| Evaluation | | Thermal conduction | Thermal conductivity | W/m·K | 4.8 | 1.1 | 1.2 | 1.2 |
| | | Bonding force | Shear joining force at 23°C | MPa | 2 | 2 | 2 | 2 |
| | | | Shear joining force at 80°C | MPa | 2 | 2 | 2 | 2 |
| | | Adhesion to irregularities | | - | Good | Good | Good | Good |
| | | Convenience | Joining process time | - | 2 min | 2 min | 2 min | 2 min |
| | | | Recycling property | - | Good | Good | Good | Good |
| | | | Repairing property | - | Good | Good | Good | Good |
| | | | Open time evaluation | - | Good | Good | Good | Good |

Table 1-1 (continued)

| | | | | Example 9 | Example 10 | Example 11 |
|---|---|---|---|---|---|---|
| Composition | | Substrate A | Kind | - | Aluminum | Aluminum | Aluminum |
| | | Substrate B | Kind | - | Aluminum | Aluminum | Aluminum |
| | | Substrate C | Kind | - | - | - | - |
| | | Joining method | | | c method | c method | c method |
| | Base resin | No | | | L-4 | L-5 | L-6 |
| | | Kind | - | | Epoxy resin | Epoxy resin | Epoxy resin |
| | | Weight-average molecular weight | - | | 11000 | 33000 | 50000 |
| | | Heat of fusion | J/g | | No melting peak | 11 | No melting peak |
| | | Tg | °C | | 101 | 75 | 123 |
| | | Melting point | °C | | 171 | 145 | 193 |
| | | Epoxy equivalent | g/eq | | 1950 | 1745 | Equal to or higher than detection limit |
| | | Heat dissipation filler | - | | Alumina | Alumina | Silver particles |
| | | Heat dissipation filler content | % by volume | | 46 | 46 | 46 |
| Evaluation | Thermal conduction | Thermal conductivity | W/m·K | | 1.2 | 0.9 | 0.9 |
| | Bonding force | Shear joining force at 23°C | MPa | | 1 | 2 | 2 |
| | | Shear joining force at 80°C | MPa | | 1 | 1 | 1 |
| | Adhesion to irregularities | | - | | Good | Good | Good |
| | Convenience | Joining process time | - | | 2 min | 2 min | 2 min |
| | | Recycling property | - | | Good | Good | Good |
| | | Repairing property | - | | Good | Good | Good |
| | | Open time evaluation | - | | Good | Good | Good |

Table 1-1 (continued)

| | | | | Example 12 | Example 13 | Example 14 |
|---|---|---|---|---|---|---|
| Composition | | Substrate A | Kind | - | Aluminum | Aluminum | Aluminum |
| | | Substrate B | Kind | - | Aluminum | Aluminum | Aluminum |
| | | Substrate C | Kind | - | - | - | - |
| | | Joining method | | | c method | c method | c method |
| | | Base resin | No | | L-6 | R-2 | R-1 |
| | | | Kind | - | Phenoxy resin + crystalline polyamide | Epoxy resin | Crystalline polyamide |
| | | | Weight-average molecular weight | - | - | 5000 | 32000 |
| | | | Heat of fusion | J/g | 25 | No melting peak | No melting peak |
| | | | Tg | °C | - | 95 | - |
| | | | Melting point | °C | 100 | 165 | 100 |
| | | | Epoxy equivalent | g/eq | - | 905 | Equal to or higher than detection limit |
| | | Heat dissipation filler | | - | Alumina | Alumina | Alumina |
| | | Heat dissipation filler content | | % by volume | 46 | 46 | 46 |
| Evaluation | | Thermal conduction | Thermal conductivity | W/m·K | 0.9 | 1.3 | 1.2 |
| | | Bonding force | Shear joining force at 23°C | MPa | 1 | 1 | 2 |
| | | | Shear joining force at 80°C | MPa | 1 | 1 | 0 |
| | | Adhesion to irregularities | | - | Good | Good | Good |
| | | Convenience | Joining process time | - | 2 min | 2 min | 2 min |
| | | | Recycling property | - | Good | Good | Good |
| | | | Repairing property | - | Good | Good | Good |
| | | | Open time evaluation | - | Good | Good | Good |

[Table 1-2]

Table 1-2

| | | | | Comparative Example 1 | Comparative Example 2 | Comparative Example 3 |
|---|---|---|---|---|---|---|
| Composition | | Substrate A | Kind | - | Aluminum | Aluminum | Aluminum |
| | | Substrate B | Kind | - | Aluminum | Aluminum | Aluminum |
| | | Substrate C | Kind | - | - | - | - |
| | | Joining method | | | c method | c method | c method |
| | | Base resin | No | | R-3 | | |
| | | | Kind | - | Crystalline epoxy resin | Thermosetting epoxy | Phenoxy resin |
| | | | Weight-average molecular weight | - | 340 | Not measurable | 50000 |
| | | | Heat of fusion | J/g | 70 | No melting peak | No melting peak |
| | | | Tg | °C | - | 140 | 123 |
| | | | Melting point | °C | 60 | - | 193 |
| | | | Epoxy equivalent | g/eq | 192 | Equal to or higher than detection limit | Equal to or higher than detection limit |
| | | Filler | | - | Alumina | Alumina | - |
| | | Filler content | | % by volume | 46 | 46 | 0 |
| Evaluation | | Thermal conduction | Thermal conductivity | W/m·K | 0.7 | 1 | 0.3 |
| | | Bonding force | Shear joining force at 23°C | MPa | 0 | 0 | 13 |
| | | | Shear joining force at 80°C | MPa | 0 | 0 | 10 |
| | | Adhesion to irregularities | | - | Poor | Poor | Good |
| | | Convenience | Joining process time | - | 2 min | 2 min | 2 min |
| | | | Recycling property | - | Good | Good | Good |
| | | | Repairing property | - | Good | Good | Good |
| | | | Open time evaluation | - | Good | Good | Good |

As shown in Table 1-1, the solid thermally-conductive material used in the joining method according to the present invention has a high thermally-conductive property and joining force. In addition to the characteristics, the solid thermally-conductive material used in the joining method according to the present invention has the following characteristics.

The solid thermally-conductive material used in the joining method according to the present invention is thermoplastic, and softening and/or melting and curing can be reversibly repeated, and therefore the solid thermally-conductive material can be stored in a solid state before incorporation in an electronic device, and can be converted to a liquid state at an incorporation portion and then inserted as a solid. Since the solid thermally-conductive material can be stored in a solid state before incorporation into an electronic device, a special technique is not required for storage and incorporation operations, and the solid thermally-conductive material is excellent in suitability for existing production lines. Accordingly, the present invention can overcome "low suitability for production lines" that is the disadvantage of the conventional liquid TIM.

The solid thermally-conductive material used in the joining method according to the present invention contains a thermoplastic resin, and therefore the solid thermally-conductive material can be melted at an incorporation portion, conform to irregularities, which are a complicated shape, to come into close contact with the irregularities, and then be solidified. Therefore, the solid thermally-conductive material is excellent in adhesion to irregularities and has high suitability for each design as shown in Table 1-1. Accordingly, the present invention can overcome "low suitability for design" that is the disadvantage of the conventional sheet-shaped TIM.

The solid thermally-conductive material used in the joining method according to the present invention contains a thermoplastic resin in an amount of 51% by mass or more of the resin component in the solid thermally-conductive material, and therefore softening and/or melting and curing can be reversibly repeated. Therefore, pump-out does not occur, voids are less liable to be generated, and a reduction in performance due to long-term use and repetition use can be avoided. Accordingly, the present invention can overcome "a reduction in performance due to long-term use and repetition use" that is the disadvantage of the conventional thermal grease.

Industrial Applicability

The joining method of the present invention is suitable for an application in which a TIM that has high suitability for existing production lines and high suitability for design, and is less prone to reduce the performance due to long-term use and repetition use is inserted in an electronic device.

The joining method of the present invention may be used in a process for producing a semiconductor package, and the solid thermally-conductive material used in the joining method of the present invention can also be utilized as a film-shaped adhesive material for a semiconductor chip. For example, the solid thermally-conductive material can be utilized as a die bonding film. In this case, the solid thermally-conductive material may be used as a dicing-die bonding unitary film including a laminated dicing tape.

Reference Signs List

A    heating element
B    heat dissipation part
B2    heat dissipation part
B3    heat dissipation part
C    solid thermally-conductive material

**Claims**

1. A method for joining a heating element A to a heat dissipation part B or a heat dissipation part B2 to a heat dissipation part B3 through a solid thermally-conductive material containing a thermoplastic resin and a heat dissipation filler, the thermoplastic resin having a content of 51% by mass or more of a resin component in the solid thermally-conductive material.

2. The joining method according to claim 1, wherein the solid thermally-conductive material is joined to the heat dissipation part B, and then brought into surface contact of the heating element A in a state where the solid thermally-conductive material is joined to the heat dissipation part B, and the solid thermally-conductive material is melted and solidified to join the heating element A to the heat dissipation part B, or the solid thermally-conductive material is joined to the heat dissipation part B3, and then brought into surface contact of the heat dissipation part B2 in a state where the solid thermally-conductive material is joined to the heat dissipation part B3, and the solid thermally-conductive material is melted and solidified to join the heat dissipation part B2 to the heat dissipation part B3.

3. The joining method according to claim 1, wherein the solid thermally-conductive material is joined to the heating element A, and then brought into surface contact with the heat dissipation part B in a state where the solid thermally-conductive material is joined to the heating element A, and the solid thermally-conductive material is melted and solidified to join the heating element A to the heat dissipation part B.

4. The joining method according to claim 1, wherein the solid thermally-conductive material is melted and solidified in a state where the heating element A, the solid thermally-conductive material, and the heat dissipation part B are arranged in this order, to join the heating element A to the heat dissipation part B, or the solid thermally-conductive material is melted and solidified in a state where the heat dissipation part B2, the solid thermally-conductive material, and the heat dissipation part B3 are arranged in this order, to join the heat dissipation part B2 to the heat dissipation part B3.

5. The joining method according to claim 1, wherein the thermoplastic resin is an amorphous thermoplastic resin having a heat of fusion of 15 J/g or less.

6. The joining method according to claim 5, wherein the amorphous thermoplastic resin is at least any one of a thermoplastic epoxy resin and a phenoxy resin.

7. The joining method according to claim 6, wherein the amorphous thermoplastic resin is an amorphous thermoplastic resin having an epoxy equivalent of 1,600 or more or an amorphous thermoplastic resin having no epoxy group.

8. The joining method according to claim 1, wherein a content of the heat dissipation filler in the solid thermally-conductive material is 30% by volume to 95% by volume.

9. The joining method according to claim 1, wherein the heat dissipation filler is at least any one selected from the group consisting of silver, aluminum oxide, magnesium oxide, aluminum hydroxide, magnesium hydroxide, aluminum nitride, boron nitride, silicon dioxide, carbon black, carbon nanofiber, carbon nanotube, silicon carbide, and silicon nitride.

10. The joining method according to any one of claims 2 to 4, wherein the melting is performed under a heating condition of 100°C to 400°C and a pressurization condition of 0.01 MPa to 20 MPa.

11. The joining method according to any one of claims 2 to 4, wherein the solid thermally-conductive material before melting has any shape selected from the group consisting of a film, a rod, a pellet, and a powder.

[Fig. 1]

# INTERNATIONAL SEARCH REPORT

International application No.

**PCT/JP2023/046060**

| | |
|---|---|
| **A.** | **CLASSIFICATION OF SUBJECT MATTER** |

*C09J 201/00*(2006.01)i; *C09J 5/00*(2006.01)i; *C09J 7/35*(2018.01)i; *C09J 11/04*(2006.01)i; *C09J 163/00*(2006.01)i; *C09K 5/12*(2006.01)i

FI: C09J201/00; C09J11/04; C09J5/00; C09J163/00; C09J7/35; C09K5/12 E

According to International Patent Classification (IPC) or to both national classification and IPC

| | |
|---|---|
| **B.** | **FIELDS SEARCHED** |

Minimum documentation searched (classification system followed by classification symbols)

C09J1/00-201/10; C09K5/12; H05K7/20; H01L21/52; H01L21/58; H01L23/34-23/46

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| X | JP 2015-43417 A (DAI NIPPON PRINTING CO., LTD.) 05 March 2015 (2015-03-05) claim 1, paragraphs [0027]-[0028], fig. 1, example 3 | 1, 4, 9-11 |
| Y | claim 1, paragraphs [0027]-[0028], [0081], fig. 1, example 3 | 2-3, 5-8 |
| Y | WO 2013/145961 A1 (SHOWA DENKO K.K.) 03 October 2013 (2013-10-03) paragraph [0053] | 2-3 |
| Y | JP 2022-133987 A (SHOWA DENKO K.K.) 14 September 2022 (2022-09-14) paragraph [0106] | 8 |
| X | JP 2011-184668 A (SEKISUI CHEMICAL CO., LTD.) 22 September 2011 (2011-09-22) claim 1, paragraphs [0007], [0009], [0016], [0037], [0047], table 1, example 1 | 1, 4, 10-11 |
| Y | claim 1, paragraphs [0007], [0009], [0012], [0016], [0023], [0037], [0047], table 1, example 1 | 2-3, 5-8 |
| A | entire text | 9 |

☑ Further documents are listed in the continuation of Box C. ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **06 March 2024** | **19 March 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

# EP 4 640 784 A1

## INTERNATIONAL SEARCH REPORT

| | International application No. |
|---|---|
| | **PCT/JP2023/046060** |

### C. DOCUMENTS CONSIDERED TO BE RELEVANT

| Category* | Citation of document, with indication, where appropriate, of the relevant passages | Relevant to claim No. |
|---|---|---|
| X | JP 2018-188540 A (THE FURUKAWA ELECTRIC CO., LTD.) 29 November 2018 (2018-11-29) claim 1, paragraphs [0014], [0142], table 1, examples 1, 3-5, 7 | 1, 5-9 |
| Y | paragraphs [0019]-[0043] | 5-7 |
| A | entire text | 2-4, 10-11 |
| A | WO 2022/209116 A1 (NIPPON STEEL CHEMICAL & MATERIAL CO., LTD.) 06 October 2022 (2022-10-06) paragraph [0020] | 5-7 |

Form PCT/ISA/210 (second sheet) (July 2022)

28

## INTERNATIONAL SEARCH REPORT
### Information on patent family members

International application No.

**PCT/JP2023/046060**

| Patent document cited in search report | | | Publication date (day/month/year) | Patent family member(s) | Publication date (day/month/year) |
|---|---|---|---|---|---|
| JP | 2015-43417 | A | 05 March 2015 | (Family: none) | |
| WO | 2013/145961 | A1 | 03 October 2013 | US 2015/0037575 A1 paragraph [0076] | |
| JP | 2022-133987 | A | 14 September 2022 | (Family: none) | |
| JP | 2011-184668 | A | 22 September 2011 | (Family: none) | |
| JP | 2018-188540 | A | 29 November 2018 | (Family: none) | |
| WO | 2022/209116 | A1 | 06 October 2022 | (Family: none) | |

Form PCT/ISA/210 (patent family annex) (July 2022)

**EP 4 640 784 A1**

REFERENCES CITED IN THE DESCRIPTION

**Patent documents cited in the description**

- JP 2006188638 A
- JP 2010021165 A
- JP 2020013872 A